# EUROPEAN PATENT SPECIFICATION

(11) **EP 1 416 327 B1**
(45) Date of publication and mention of the grant of the patent: **20.06.2007**
(21) Application number: 03256882.6
(22) Date of filing: 30.10.2003
(51) Int. Cl.: G03F 7/20

(54) **Inspection method and device manufacturing method**
Untersuchungsverfahren und Verfahren zur Herstellung einer Vorrichtung
Procédé d'inspection et méthode de fabrication d'un dispositif

(30) Priority: 01.11.2002 EP 02257610
(43) Date of publication of application: 06.05.2004
(73) Proprietor: ASML Netherlands B.V., 5504 DR Veldhoven (NL)
(72) Inventor: Den Boef, Arie Jeffrey, 5581 AB Waalre (NL); Dusa, Mircea, Campbell, California 95008-5134 (US)
(74) Representative: Leeming, John Gerard

(56) References cited:
- WO-A-02/065545
- US-A1- 2002 041 373
- US-A1- 2002 072 003
- US-B1- 6 296 977
- US-B1- 6 458 605
- BISCHOFF J. ET AL: 'OPTICAL SCATTEROMETRY OF QUARTER MICRON PATTERNS USING NEURAL REGRESSION' PROCEEDINGS OF THE SPIE, SPIE, BELLINGHAM, VA, US vol. 3332, 1998, pages 526 - 537, XP000890149

## Description

The present invention relates to methods of inspection useable in the manufacture of devices by lithographic techniques and to methods of manufacturing devices using lithographic techniques.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

The measurement and inspection step after development of the resist, referred to as in-line because it is carried out in the normal course of processing production wafers, serves two purposes. Firstly, it is desirable to detect any target areas where the pattern in the developed resist is faulty. If a sufficient number of dies are faulty, the wafer can be stripped of the patterned resist and re-exposed, hopefully correctly, rather than making the fault permanent by carrying out a process step, e.g. an etch, with a faulty pattern. Secondly, the measurements may allow errors in the lithographic apparatus, e.g. in illumination settings or exposure times, to be detected and corrected for subsequent exposures. However, many errors in the lithographic apparatus cannot easily be detected or quantified from the patterns printed in exposures. Detection of a fault does not always lead directly to its cause. Thus, a variety of off-line procedures for detecting and measuring errors in the lithographic apparatus are known. These may involve replacing the substrate with a measuring device or carrying out exposures of special test patterns, e.g. at a variety of different machine settings. Such off-line techniques take time, often a considerable amount, during which the apparatus cannot be used for production exposures. Therefore, in-line techniques, that is ones which can be carried out using or at the same time as production exposures, for detecting and measuring errors in the lithographic apparatus are preferred.

To measure dimensional errors, such as overlay and left-right dimensional differences caused by comatic aberration, image-based tools, such as box-in-box (or frame-in-frame) for overlay and scanning electron microscopes (SEM) to measure critical dimensions (CD) for coma, are used at present. These techniques, as well as being off-line, have the disadvantage that they make localized measurements which do not necessarily accurately reflect the projection system or process behavior over the full die or target area.

One in-line technique used in device manufacturing for measurements of linewidth, pitch and critical dimension (CD) is known as "scatterometry". Methods of scatterometry are described in Raymond et al "Multiparameter Grating Metrology Using Optical Scatterometry", J. Vac. Sci. Tech. B, Vo1.15 no.2 361-368 1997 and Niu et al "Specular Spectroscopic Scatterometry in DUV Lithography", SPIE, Vol. 3677, 1999. In scatterometry, white light is reflected by periodic structures in the developed resist and the resulting reflection spectrum at a given angle detected. The structure giving rise to the reflection spectrum is reconstructed, e.g. using Rigorous Coupled-Wave Analysis (RCWA) or by comparison to a library of spectra derived by simulation. However, the reconstruction of the structure is computationally very intensive and the technique can suffer from low sensitivity and poor repeatability.

Other disclosures of the use of scatterometry in lithography include WO 02/065545 which proposes to measure overlay by scatterometry measurements from two overlying gratings. It suggests that if a sample of one of the gratings not overlain by the other is available, measurements may be taken to constrain the measurement of overlay derived from the two overlying gratings. US 6,458,605 and US 2002/0041373 utilize reference libraries derived from measurements of reference structures to aid in derivation of information from scatterometry measurements. US 2002/0041373 proposes printing a randomly distributed focus-energy matrix (FEM) of identical test gratings on a wafer and derives information from scatterometry measurements thereof, especially from differences between scatterometry measurements from different gratings in the matrix.

WO 02/065545 proposes the use of scatterometry on overlying gratings to measure overlay. Reconstruction of the overlying gratings may be constrained by measurements derived from separate copies of the gratings.

WO 02/065545 discloses an inspection method comprising:
using a lithographic apparatus to print onto a substrate a test pattern comprising a combination of first and second pattern components, said first pattern component being different from said second pattern component;
using a lithographic apparatus to print onto said substrate a reference pattern corresponding respectively to one of said first and second pattern components;
using a scatterometer to measure first and second reflection spectra of said test pattern and said; and
deriving from said first and second reflection spectra information indicative of a parameter of said test pattern on said substrate, wherein said first and second pattern components differ in form.

WO 02/065545 does not disclose a second reference grating and printing all the components of the test pattern and the reference patterns at the same time.

US 6,296,977 B1 discloses an inspection method comprising:
using a lithographic apparatus to print onto a substrate a test pattern comprising a combination of first and second pattern components, said first pattern component being different from said second pattern component;
using a lithographic apparatus to print onto said substrate first and second reference patterns corresponding respectively to said first and second pattern components;
measuring said test pattern and said first and second reference patterns; and deriving from said measurements information indicative of a parameter of said test pattern on said substrate, wherein said first and second pattern components differ in form.

US 6,296,977 B1 does not disclose using scatterometry and printing all the components of the test pattern and the reference patterns at the same time.

It is an object of the present invention to provide an in-line method of making measurements during manufacture of devices using lithographic techniques that has improved accuracy, sensitivity and/or repeatability.

This and other objects are achieved according to the invention an inspection method comprising:
using a lithographic apparatus to print onto a substrate a test pattern comprising a combination of first and second pattern components, said first pattern component being different from said second pattern component;
using a lithographic apparatus to print onto said substrate first and second reference patterns corresponding respectively to said first and second pattern components;
using a scatterometer to measure first, second and third reflection spectra of said test pattern and said first and second reference patterns respectively; and
deriving from said first, second and third reflection spectra information indicative of a parameter of said test pattern on said substrate, wherein
said first and second pattern components differ in form; and
said first and second reference patterns and the first and second pattern components are printed at the same time.

By this method, a rapid, accurate and repeatable measurement of a parameter of the test pattern as printed on the substrate can be made. The test and reference patterns can be printed in the course of a production exposure, for example in a scribe lane or edge die or other unused area of the substrate, without requiring significant additional time. The reflection spectra can be measured by the scatterometer equally quickly and without delaying the production line. The measurement method of the invention can therefore be used in-line, as a qualification or calibration tool.

The addition of the reference patterns improves the sensitivity as compared to scatterometry techniques using a single test pattern and can simplify the process of deriving the desired information from the scatterometry data. In some cases, reconstruction of the reference patterns is simpler than reconstruction of the two-component test pattern and is performed first. The results of the reconstruction of the reference pattern are then used to simplify reconstruction of the test pattern. In other cases, the desired information can be obtained directly from comparison of the different spectra, without the necessity for reconstruction of the test pattern.

In a preferred embodiment of the invention, the first and second pattern components comprise single bar gratings having different pitches which are combined into a test pattern comprising a two-bar grating pattern having an inner pitch and an outer pitch. The first and second reference patterns comprise respectively a single bar grating having a pitch equal to the inner pitch and a single bar grating having a pitch equal to the outer pitch. The scatterometry signals from the reference gratings contain information as to the form of the two components of the two-bar grating and enable the asymmetry information that is indicative of coma to be isolated from the scatterometry response of the test pattern.

Preferably the scatterometry step is carried out on the pattern in developed resist although if there is sufficient contrast in the latent resist image, the scatterometry step may be carried out before development. Because the aberration is detected before a process step is carried out, if the aberration is severe enough to result in a defective device, the resist can be stripped and the substrate put back into the process for re-imaging.

Preferably, the scatterometry step(s) is (are) carried out using normal incidence, white light scatterometry.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section, said pattern comprising: a pattern representing a process layer; a test pattern comprising a combination of first and second pattern components, said first pattern component being different from said second pattern component; and first and second reference patterns corresponding respectively to said first and second pattern components;
- projecting the patterned beam of radiation onto a target portion of the layer of radiation-sensitive material;

using a scatterometer to measure first, second and third reflection spectra of said test pattern and said first and second reference patterns respectively; and
deriving from said first, second and third reflection spectra information indicative of a parameter of said test pattern on said substrate; wherein
said first and second pattern components differ in form; and
said first and second reference patterns and the first and second pattern components are printed at the same time.

Preferably, the test pattern is printed in an area adjacent the pattern of the production layer, such as a scribe lane. In this way, no unnecessary space is taken up on the substrate and a maximum area remains for production of devices.

In a preferred embodiment of this aspect of the invention, said information indicative of a parameter is used to adjust a parameter of the lithographic apparatus or process after which a further substrate is provided and said steps of providing a projection beam, using patterning means and projecting the patterned beam, are repeated. In this way, the results of scatterometry measurements taken on one substrate can be used to adjust the lithographic apparatus or process so that subsequent exposures are improved.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

An embodiment of the invention and an example not forming part of the invention will now be described, by way of example only, with reference to the accompanying schematic drawings in which:
Figure 1 depicts a lithographic projection apparatus that may be used in the performance methods according to the invention;
Figure 2 is a flow diagram of a lithographic process according to an embodiment of the invention;
Figure 3 depicts a scatterometer useable in methods according to the present invention;
Figures 4 to 6 depict a test pattern and first and second reference patterns used in a first method according to an example not forming part of the present invention;
Figure 7 depicts a raw overlay signal and an overlay signal enhanced according to the first method according to an example not forming part of the present invention; and
Figures 8 to 10 depict a test pattern and first and second reference patterns used in a second method according to the present invention.

In the Figures, corresponding reference symbols indicate corresponding parts.

### Lithographic Projection Apparatus

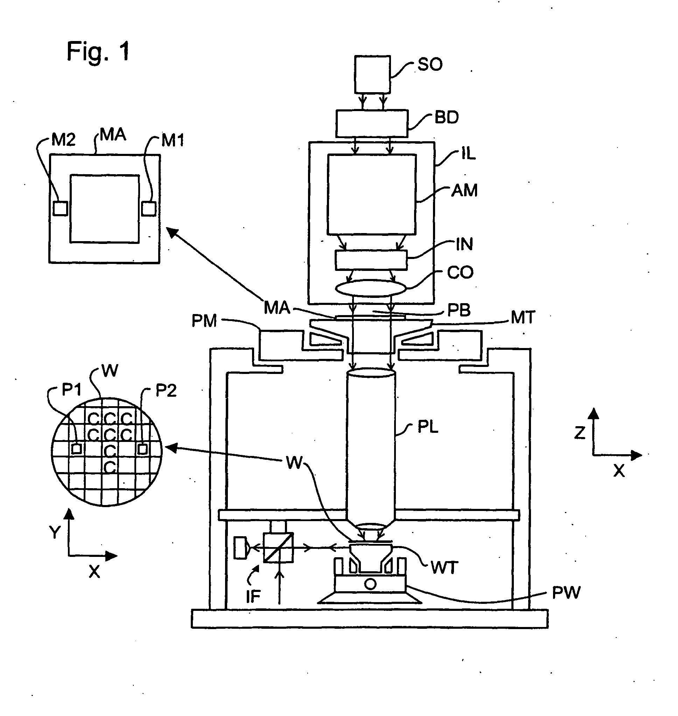

Figure 1 schematically depicts a lithographic apparatus according to a particular embodiment of the invention. The apparatus comprises:
- an illumination system (illuminator) IL for providing a projection beam PB of radiation (e.g. UV radiation or DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M 1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

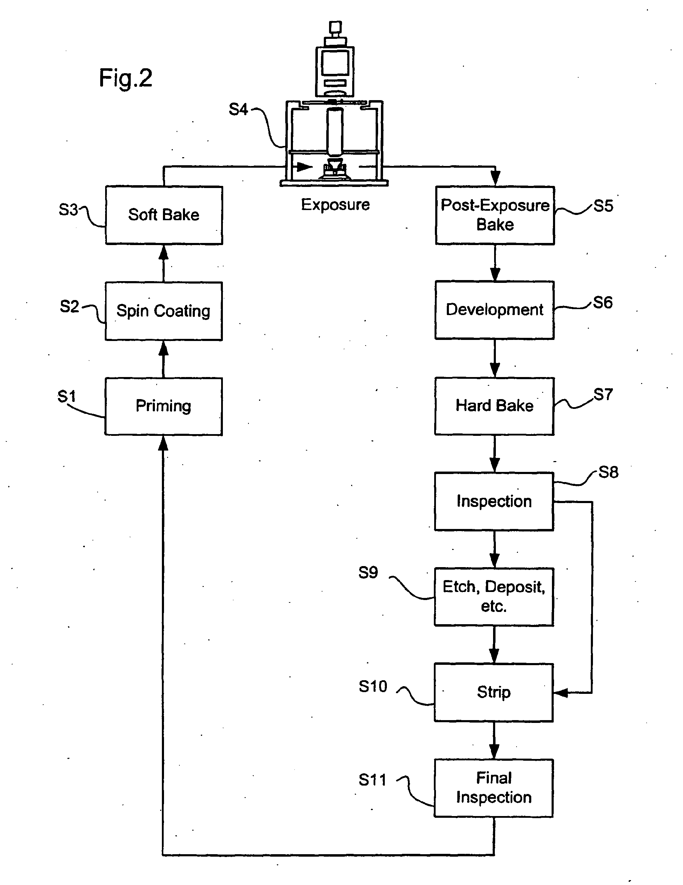

Figure 2 is a flow diagram of a lithographic process of which the present invention may form part. Prior to the exposure step S4, which may be carried out using a lithographic apparatus such as described above with relation to Figure 1, a substrate, e.g. a silicon wafer, undergoes a priming step S1, spin coating step S2 to coat it with a layer of resist and a soft bake S3 to remove solvents from the resist. After exposure, the wafer undergoes a post-exposure bake S5, a development step S6 during which the exposed or unexposed resist (depending on whether the resist is positive or negative) is removed and a hard bake S7, prior to an inspection step S8. The inspection step S8 includes various different measurements and inspections and according to the invention includes a scatterometry step described further below. If the wafer passes inspection, a process step S9 is carried out. This may involve etching the areas of the substrate not covered by resist, deposition of a product layer, metallization, ion implantation, etc. After the process step S9 the remaining resist is stripped S10 and a final inspection S 11 carried out before the process resumes for another layer. In case a substrate fails an inspection at S8, it may be directed directly to a stripping step S 10 and another attempt to print the same process layer made.

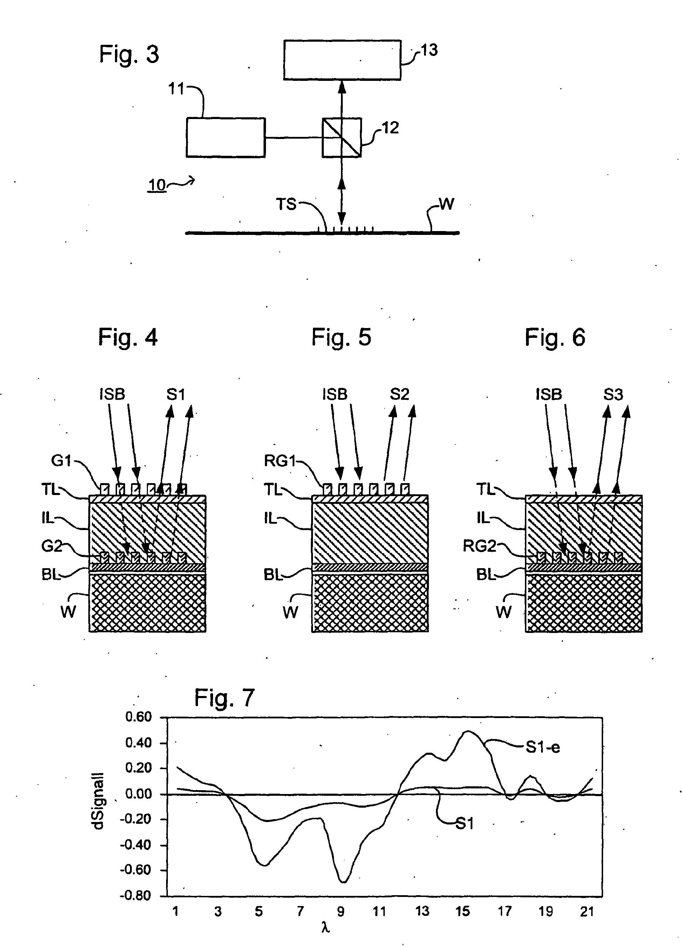

In the inspection step S8, a scatterometer such as depicted in Figure 3 may be used. Other inspections and/or measurements may also be made using other tools. The scatterometer 10 comprises a broadband (white light) radiation source 11 which directs radiation via a beamsplitter 12 onto a test structure TS on the wafer W. The reflected radiation is passed to a spectrometer 13 which measures a spectrum (intensity as a function of wavelength) of the specular reflected radiation. From this data, the structure giving rise to the detected spectrum may be reconstructed, e.g. by Rigorous Coupled Wave Analysis and nonlinear regression or by comparison with a library of simulated spectra. In general, for the reconstruction the general form of the structure is known and some parameters are assumed from knowledge of the process by which the structure was made, leaving only a few parameters of the structure to be determined from the scatterometry data.

As illustrated, the scatterometer is a normal-incidence scatterometer. However the same principle may be applied using inclined incidence scatterometry. Variants of scatterometry in which the reflection at a range of angles of a single wavelength, rather than the reflection at a single angle of a range of wavelengths, is measured may also be used.

### Example not forming part of the invention

According to a first method of the invention, which is used to measure overlay, the test structure printed on the substrate W comprises a first mark, or first pattern component, G1 printed in an upper process layer TL and a second mark, or second pattern component, G2 printed in a lower process layer BL. The marks G1 and G2 may take any convenient form, such as gratings, checkerboards, boxes, frames, chevrons, etc.. The form of the marks is chosen for ease of reconstruction, in particular the use of gratings allows rapid reconstruction techniques to be used. The mark type can also be chosen to improve sensitivity. The two marks G1 and G2 should be, if printed perfectly and unaffected by subsequent processes, identical and in the absence of overlay error, exactly aligned. Though identical in form, the first and second marks (pattern components) are different in their location in the process layers on the substrate. When the test pattern comprising marks G1, G2 is illuminated with normally incident polarized light the reflected TE, TM or phase signal contains information about the relative position of the two gratings. However, due to internal reflections in the intervening process layers IL between the upper and lower layers TL, BL containing the gratings G1, G2 and interference, the amplitude of the total reflected signal containing overlay information is very weak and has a low signal-to-noise ratio. Further noise is introduced by distortions in the marks G1, G2 during printing and, in the case of the lower mark G2, by the processes that have being carried out since it was printed.

According to the present invention, to improve measurement of overlay, two reference marks RG1, RG2 are printed at the same time as the two parts G1, G2 of the test pattern. Reference pattern RG1 is provided in the top layer TL and corresponds to the first mark G 1. Reference pattern RG2 is provided in the bottom layer BL and corresponds to the second alignment mark G2. The reference patterns RG1, RG2 are printed close to but spaced apart from each other and the test pattern comprising alignment marks G1, G2. The reference markers RG 1, RG2 and the test pattern should be close enough together that they will be affected in the same way by any distortions in the printing process or caused by subsequent process steps. At the same time, they should be sufficiently far apart that separate scatterometry measurements can be taken, without crosstalk.

When illuminated in the same way as the test pattern, the reference patterns RG1, RG2 produce scatterometry signals S2, S3 which contain information only about the respective gratings. The scatterometry signals S2, S3 can then be used to normalize the scatterometry signal S 1 to provide an enhanced scatterometry signal S1-e. An example of this is shown in Figure 7 from which it can be seen that the enhanced signal S1-e has a much higher amplitude but retains the same phase position fingerprint of the original signal. The signal-to-noise ratio is effectively improved. The enhanced overlay signal is derived from three specular spectroscopic signals. The first is the "raw" overlay signal generated by the two overlying gratings. The second and third are the signal generated by the bottom and top reference gratings. The enhanced overlay signal is then derived by dividing the raw overlay signal by the signal from the top reference grating minus the signal from the bottom reference grating.

### Embodiment

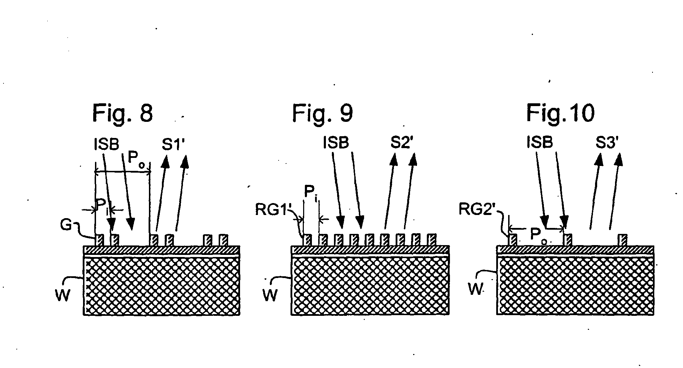

A grating structure used in a second method of the present invention is depicted in Figures 8 to 10. The second method of the present invention measures differential dimensional asymmetry due to comatic aberration in the lithographic apparatus, particularly the projection system PL, or the process applied to the substrate.

As shown in Figure 8, the test pattern G comprises a two-bar grating having an inner pitch Pᵢ and an outer pitch Pₒ. The first pattern component comprises a single-bar grating of pitch equal to the inner pitch and the second pattern component to a single-bar grating of pitch equal to the outer pitch. The two reference gratings RG1', RG2' are shown in Figures 9 and 10 and comprise respectively a simple grating of pitch Pᵢ and a simple grating of pitch Pₒ.

As in the first method, the test pattern G and reference patterns RG1', RG2' are illuminated identically with specular polarized light. The resulting reflectance spectra S1', S2', S3' contain information about any differential dimensional asymmetries as well as the actual forms of the gratings. The information about any differential dimensional asymmetry is contained in the reflectance spectra S1' from the dual pitch grating whilst the spectra S2', S3' contain information about the gratings themselves. As in the first method, the reflectance spectra S2', S3' are used to enhance the reflectance spectra S1' to provide a signal containing information of the dimensional asymmetry with an improved signal-to-noise ratio.

Whilst a specific embodiment of the invention has been described above, it will be appreciated that the invention may be practiced otherwise than as described. The description is not intended to limit the invention which is defined by the claims.

## Claims

1. An inspection method comprising:
using a lithographic apparatus to print onto a substrate a test pattern (G) comprising a combination of first and second pattern components, said first pattern component being different from said second pattern component;
using a lithographic apparatus to print onto said substrate first and second reference patterns (RG1, RG2) corresponding respectively to said first and second pattern components;
using a scatterometer to measure first, second and third reflection spectra (S1', S2' S3') of said test pattern and said first and second reference patterns respectively; and
deriving from said first, second and third reflection spectra information indicative of a parameter of said test pattern on said substrate, wherein
said first and second pattern components differ in form; and
said first and second reference patterns and the first and second pattern components are printed at the same time.

2. An inspection method according to claim 1 wherein said test pattern (G) comprises a two-bar grating pattern having an inner pitch and an outer pitch and said first and second reference patterns (RG1, RG2) comprise respectively a single bar grating having a pitch equal to the inner pitch and a single bar grating having a pitch equal to the outer pitch.

3. An inspection method according to any one of the preceding claims wherein said scatterometer is a normal incidence scatterometer.

4. An inspection method according to any one of the preceding claims wherein said step of deriving information comprises reconstructing said first and second reference patterns using said first and second reflection spectra and using the reconstructed reference patterns to reconstruct said test pattern.

5. An inspection method according to any one of claims 1 to 3 wherein in said step of deriving, said information is obtained directly from said reflection spectra, without reconstruction of the test pattern.

6. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section, said pattern comprising: a pattern representing a process layer; a test pattern (G) comprising a combination of first and second pattern components, said first pattern component being different from said second pattern component; and first and second reference patterns (RG1, RG2) corresponding respectively to said first and second pattern components;
- projecting the patterned beam of radiation onto a target portion of the layer of radiation-sensitive material;
using a scatterometer to measure first, second and third reflection spectra (S1', S2', S3') of said test pattern and said first and second reference patterns respectively; and
deriving from said first, second and third reflection spectra information indicative of a parameter of said test pattern on said substrate; wherein
said first and second pattern components differ in form; and
said first and second reference patterns and the first and second pattern components are printed at the same time.

7. A device manufacturing method according to claim 6 wherein said test pattern is printed in an area adjacent the pattern of the production layer, such as a scribe lane.

8. A device manufacturing method according to claim 6 or 7 wherein said information indicative of a parameter is used to adjust a parameter of the lithographic apparatus or process after which a further substrate is provided and said steps of providing a projection beam, using patterning means and projecting the patterned beam, are repeated.

## Patentansprüche

1. Untersuchungsverfahren mit den Schritten:
Verwenden einer lithographischen Vorrichtung, um ein Testmuster (G) auf ein Substrat zu drucken, das eine Kombination aus einer ersten und einer zweiten Musterkomponente aufweist, wobei die erste Musterkomponente sich von der zweiten Musterkomponente unterscheidet;
Verwenden einer lithographischen Vorrichtung, um ein erstes und ein zweites Referenzmuster (RG1, RG2), die der ersten bzw. der zweiten Musterkomponente entsprechen, auf ein Substrat zu drucken;
Verwenden eines Streustrahlungsmessers, um ein erstes, ein zweites und ein drittes Reflektionsspektrum (S1', S2', S3') des Testmusters sowie des ersten und des zweiten Referenzmusters zu messen; und
Ableiten von Information aus dem ersten, dem zweiten und dem dritten Reflektionsspektrum, wobei die Information auf einen Parameter des Testmusters auf dem Substrat hinweist, wobei
die erste und die zweite Musterkomponente sich bezüglich ihrer Form unterscheiden; und wobei
das erste und das zweite Referenzmuster sowie die erste und die zweite Musterkomponente gleichzeitig gedruckt werden.

2. Untersuchungsverfahren nach Anspruch 1, bei dem das Testmuster (G) ein zweifaches Stabgittermuster mit einem inneren Abstand und einem äußeren Abstand aufweist, und bei dem das erste und das zweite Referenzmuster (RG1, RG2) ein einfaches Stabgitter mit einem Abstand, der gleich dem inneren Abstand ist, bzw. ein einfaches Stabgitter mit einem Abstand, der gleich dem äußeren Abstand ist, aufweisen.

3. Untersuchungsverfahren nach einem der vorhergehenden Ansprüche, bei dem der Streustrahlungsmesser ein Streustrahlungsmesser mit senkrechtem Einfall ist.

4. Untersuchungsverfahren nach einem der vorhergehenden Ansprüche, bei dem der Schritt des Ableitens von Information das Rekonstruieren des ersten und des zweiten Referenzmusters unter Verwendung des ersten und des zweiten Reflektionsspektrums sowie die Verwendung des rekonstruierten Referenzmusters umfasst, um das Testmuster zu rekonstruieren.

5. Untersuchungsverfahren nach einem der Ansprüche 1 bis 3, wobei bei dem Schritt des Ableitens die Information direkt aus den Reflektionsspektren ohne Rekonstruktion des Testmusters erhalten wird.

6. Verfahren zur Herstellung einer Vorrichtung mit den Schritten:
Bereitstellen eines Substrats, das zumindest teilweise von einer Schicht aus strahlungsempfindlichem Material überzogen ist;
Bereitstellen eines Projektionsstrahls aus Strahlung unter Verwendung eines Strahlungssystems;
Verwenden eines Musteraufbringungsmittels, um den Querschnitt des Projektionsstrahls mit einem Muster zu versehen, wobei das Muster umfasst: ein Muster, das eine Prozessschicht darstellt; ein Testmuster (G), das eine Kombination aus einer ersten und einer zweiten Musterkomponente aufweist, wobei die erste Musterkomponente sich von der zweiten Musterkomponente unterscheidet; und erste und zweite Referenzmuster (RG1, RG2), die der ersten bzw. der zweiten Musterkomponente entsprechen;
Projizieren des gemusterten Strahls aus Strahlung auf einen Zielabschnitt der Schicht aus strahlungsempfindlichem Material;
Verwenden eines Streustrahlungsmessers, um ein erstes, ein zweites und ein drittes Reflektionsspektrum (S1', S2', S3') des Testmusters sowie des ersten und des zweiten Referenzmusters zu messen; und
Ableiten von Information aus dem ersten, dem zweiten und dem dritten Reflektionsspektrum, wobei die Information auf einen Parameter des Testmusters auf dem Substrat hinweist; wobei
die erste und die zweite Musterkomponente sich bezüglich ihrer Form unterscheiden; und wobei
das erste und das zweite Referenzmuster sowie die erste und die zweite Musterkomponente gleichzeitig gedruckt werden.

7. Verfahren zum Herstellen einer Vorrichtung nach Anspruch 6, bei dem das Testmuster in einem Bereich benachbart dem Muster der Produktionsschicht, beispielsweise einer Anreißlinie, gedruckt wird.

8. Verfahren zum Herstellen einer Vorrichtung nach Anspruch 6 oder 7, bei dem die auf einen Parameter hinweisende Information dazu verwendet wird, einen Parameter der lithographischen Vorrichtung oder des Prozesses zu justieren, nach welchem ein weiteres Substrat bereitgestellt wird und die Schritte des Bereitstellens eines Projektionsstrahls, Verwenden eines Musteraufbringungsmittels und Projizieren des gemusterten Strahls wiederholt werden.

## Revendications

1. Procédé d'inspection comprenant :
l'utilisation d'un appareil lithographique pour imprimer sur un substrat un motif test (G) comprenant une combinaison de premier et second composants de motif, ledit premier composant de motif étant différent dudit second composant de motif ;
l'utilisation d'un appareil lithographique pour imprimer sur ledit substrat des premier et second motifs de référence (RG1, RG2) correspondant respectivement auxdits premier et second composants de motif ;
l'utilisation d'un diffusomètre pour mesurer des premier, deuxième et troisième spectres de réflexion (S1', S2', S3') dudit motif test et desdits premier et second motifs de référence, respectivement ; et
l'obtention à partir desdits premier, deuxième et troisième spectres de réflexion, d'informations indicatives d'un paramètre dudit motif test sur ledit substrat, dans lequel
lesdits premier et second composants de motif diffèrent en forme ; et
lesdits premier et second motifs de référence et les premier et second composants de motif sont imprimés en même temps.

2. Procédé d'inspection selon la revendication 1, dans lequel ledit motif test (G) comporte un motif de réseau à deux barres ayant un pas intérieur et un pas extérieur et lesdits premier et second motifs de référence (RG1, RG2) comprennent respectivement un réseau à barres uniques ayant un pas égal au pas intérieur et un réseau à barres uniques ayant un pas égal au pas extérieur.

3. Procédé d'inspection selon l'une quelconque des revendications précédentes, dans lequel ledit diffusomètre est un diffusomètre à incidence normale.

4. Procédé d'inspection selon l'une quelconque des revendications précédentes, dans lequel ladite étape d'obtention d'informations comporte la reconstruction desdits premier et second motifs de référence en utilisant lesdits premier et deuxième spectres de réflexion et en utilisant les motifs de référence reconstruits pour reconstruire ledit motif test.

5. Procédé d'inspection selon l'une quelconque des revendications 1 à 3, dans lequel, au cours de ladite étape d'obtention, lesdites informations sont obtenues directement à partir desdits spectres de réflexion, sans reconstruction du motif test.

6. Procédé de fabrication de dispositif comportant les étapes consistant à :
- fournir un substrat qui est au moins partiellement recouvert d'une couche de matériau sensible au rayonnement ;
- fournir un faisceau de projection de rayonnement en utilisant un système de rayonnement ;
- utiliser les moyens de mise en forme pour doter le faisceau de projection d'un motif dans sa section transversale, ledit motif comprenant : un motif représentant une couche de traitement ; un motif test (G) comprenant une combinaison de premier et second composants de motif, ledit premier composant de motif étant différent dudit second composant de motif ; et des premier et second motifs de référence (RG1, RG2) correspondant respectivement auxdits premier et second composants de motif ;
- projeter le faisceau de rayonnement mis en forme sur une partie cible de la couche de matériau sensible au rayonnement ;
utiliser un diffusomètre pour mesurer les premier, deuxième et troisième spectres de réflexion (S1', S2', S3') dudit motif test et desdits premier et second motifs de référence, respectivement ; et
obtenir à partir desdits premier, deuxième et troisième spectres de réflexion, des informations indicatives d'un paramètre dudit motif test sur ledit substrat ; dans lequel
lesdits premier et second composants de motif diffèrent en forme ; et
lesdits premier et second motifs de référence et les premier et second composants de motif sont imprimés en même temps.

7. Procédé de fabrication de dispositif selon la revendication 6, dans lequel ledit motif test est imprimé dans une zone à proximité du motif de la couche de production, comme un chemin de découpe.

8. Procédé de fabrication de dispositif selon la revendication 6 ou 7, dans lequel lesdites informations indicatives d'un paramètre sont utilisées pour ajuster un paramètre de l'appareil ou du traitement lithographique après quoi un substrat supplémentaire est fourni et lesdites étapes consistant à fournir un faisceau de projection, utiliser des moyens de mise en forme et projeter le faisceau mis en forme, sont répétées.
